# EUROPEAN PATENT SPECIFICATION

(11) **EP 4 254 647 B1**
(45) Date of publication and mention of the grant of the patent: **25.11.2026**
(21) Application number: 22908827.3
(22) Date of filing: 23.12.2022
(51) Int. Cl.: H01M 50/60, H01M 10/04, H01M 10/44, H01M 10/052

(54) **METHOD FOR MANUFACTURING LITHIUM SECONDARY BATTERY**
VERFAHREN ZUR HERSTELLUNG EINER LITHIUMSEKUNDÄRBATTERIE
PROCÉDÉ DE FABRICATION DE BATTERIE RECHARGEABLE AU LITHIUM

(30) Priority: 27.12.2021 KR 20210188409
(43) Date of publication of application: 04.10.2023
(73) Proprietor: LG Energy Solution, Ltd., Seoul 07335 (KR)
(72) Inventor: CHA, In Young, Daejeon 34122 (KR); SUNG, Nak Gi, Daejeon 34122 (KR); LEE, Jung Mi, Daejeon 34122 (KR)
(74) Representative: Goddar, Heinz J.
(86) International application number: PCT/KR2022/021220
(87) International publication number: WO 2023/128492

(56) References cited:
- CN-A- 106 505 251
- KR-A- 20110 033 640
- KR-A- 20120 060 708
- KR-A- 20140 004 662
- KR-A- 20140 018 014
- KR-A- 20170 022 391
- US-A1- 2014 001 035
- US-A1- 2021 354 054
- NAKADAI K ET AL: "Towards New Human-Humanoid Communication: Listening During Speaking by Using Ultrasonic Directional Speaker", ROBOTICS AND AUTOMATION, 2005. PROCEEDINGS OF THE 2005 IEEE INTERNATIONAL CONFERENCE ON BARCELONA, SPAIN 18-22 APRIL 2005, PISCATAWAY, NJ, USA,IEEE, 18 April 2005 (2005-04-18), pages 1483 - 1488, XP010871845, ISBN: 978-0-7803-8914-4, DOI: 10.1109/ROBOT.2005.1570324

## Description

### [Technical Field]

The present invention relates to a manufacturing method of a lithium secondary battery, and more specifically, to a manufacturing method of a lithium secondary battery that improves wetting property of an electrolyte by removing air bubbles using a speaker immediately after injecting an electrolyte.

### [Background Technology of the Invention]

Recently, as the technology development and demand for mobile devices increase, the demand for secondary batteries as an energy source is rapidly increasing, and among such secondary batteries, a lot of research has been conducted on lithium secondary batteries having high energy density and discharge voltage, which also have been commercialized and widely used.

The lithium secondary battery has a structure in which a non-aqueous electrolyte containing a lithium salt is impregnated with an electrode assembly in which a porous separator is interposed between a positive electrode and a negative electrode on which an active material is applied on an electrode current collector.

In general, the lithium secondary battery is assembled by manufacturing an electrode assembly having a structure in which positive and negative electrodes are alternately laminated and a separator is interposed between the positive and negative electrodes, inserting the electrode assembly to a battery case made of a can or a pouch of a certain size and shape, and then finally injecting the electrolyte. Here, the electrolyte is permeated into the positive electrode, the negative electrode, and the separator by capillary force. However, while the positive electrode, the negative electrode, and the separator are all materials with high hydrophobicity due to the nature of the material, the electrolyte is a hydrophilic material, so it takes a considerable amount of time and a complicated processing conditions to increase the wetting property of the electrolyte to the electrode and the separator.

In particular, in the case of a jelly-roll type electrode assembly, as the internal structure of the battery case becomes complicated to increase the capacity and the resistance of the battery, it takes a long time for the electrolyte to penetrate into the jelly-roll type electrode assembly, and when air bubbles are formed inside, it is difficult for the electrolyte to impregnate into the jelly-roll electrode assembly even if a sufficient time has elapsed after the injection of the electrolyte, so there needs to be a process of removing these air bubbles.

Meanwhile, Korean Patent Publication No. 10-2015-0162916 discloses an electrolyte impregnating device including a holder for fixing a battery cell, and a resonant vibration applying part for applying ultrasonic waves to the holder in order to improve the wetting property of the electrolyte, and an attempt was made to utilize the same ultrasonic waves when removing air bubbles. However, a liquid medium is required for efficient transmission of ultrasonic waves, which has a significantly increased processing complexity, and since energy is transferred to the electrodes inside the battery during the process of application of ultrasonic waves, there may be side effects such as deintercalation of some active materials in the coated active material layer.

Therefore, there is a high need for a technology that can fundamentally solve these problems.

CN 106505251 A1 discloses a manufacturing method of a lithium secondary battery comprising the steps specified in the preamble of claim 1. US 2021/354054 A1 discloses a method for removing air bubbles in a solution applied on a substrate by using a directional acoustic wave. US 2014/001035 A1 discloses a method for enhancing electrolytic cell performance by sonicating an electrolyte solution at a sweeping frequency from infrasound to ultrasound.

### [Description of the Invention]

### [Technical Problem]

The present invention is directed to solve the problems of the prior art as described above and the technical problems that have been requested from the past.

Specifically, the present invention is directed to provide a method for manufacturing a lithium secondary battery that improves the wetting property of an electrolyte by removing air bubbles present in the battery case.

Another object of the present invention is to reduce the waiting time for an electrolyte impregnation by removing air bubbles inside the battery and improving the electrolyte wetting, and to improve charging uniformity in the subsequent charging process by uniformly impregnating the electrolyte.

### [Technical Solution]

A manufacturing method of a lithium secondary battery according to the present invention includes:
(a) assembling a battery cell by accommodating an electrode assembly inside a battery case, and injecting an electrolyte; and
(b) pre-aging the battery cell into which an electrolyte is injected, wherein
the pre-aging (b) includes:
(b-1) applying sound waves to the assembled battery cell using a speaker; and (b-2) aging the battery cell, and
characterised in that
the speaker is a directional speaker, and
in (b-1) applying sound waves, the frequency of the sound wave of the speaker is 20Hz to 20000Hz and the carrier wave of the directional speaker is an ultrasonic wave.

In an exemplary embodiment of the present invention, (b-1) applying sound waves may locally apply sound waves to a region where air bubbles are expected to form.

In an exemplary embodiment of the present invention, (b-1) applying sound waves may apply sound waves while sweeping the frequency of the sound wave.

The manufacturing method of a lithium secondary battery according to an exemplary embodiment of the present invention further includes (c) an activation charging of the battery cell after the (b) pre-aging.

In an exemplary embodiment of the present invention, (b-1) applying sound waves may apply sound waves in a state where the battery cell is sealed.

In an exemplary embodiment of the present invention, (b-1) applying sound waves may apply sound waves in a state where the battery cell is not sealed.

In an exemplary embodiment of the present invention, in (b-1) applying the sound wave, the frequency of the carrier wave of the directional speaker is 20kHz to 100kHz.

### [Advantageous Effects]

Since pre-aging for an electrolyte impregnation includes intensively applying sound waves to a region where air bubbles are expected to form, well-removing the air bubbles, the manufacturing method of a lithium secondary battery according to the present invention is capable of improving electrolyte wetting property.

In addition, as a result of the improvement in the electrolyte wetting property due to the removal of air bubbles, the time required for the pre-aging for electrolyte impregnation can be shortened, and since the electrolyte is uniformly impregnated into the electrode due to the removal of air bubbles, charging uniformity of the electrode can be improved in the subsequent charging process.

### [Brief Description of the Drawing]

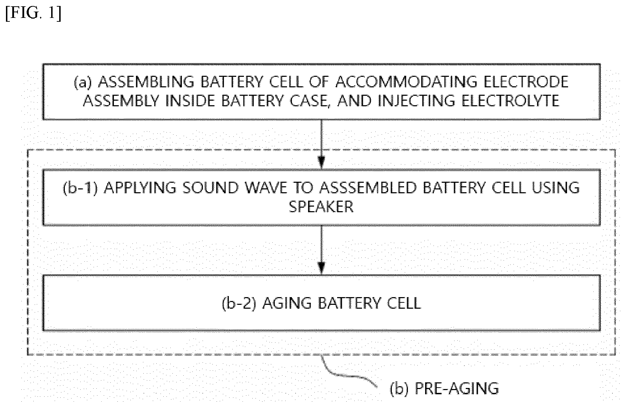

FIG. 1 is a flowchart of a manufacturing method of a lithium secondary battery according to an exemplary embodiment of the present invention.

### [Best Mode for Carrying Out the invention]

The present invention may have various modifications and various examples, and thus specific examples are illustrated in the drawings and described in detail in the description. However, it should be understood that the present invention is not limited to specific embodiments, and includes all modifications, equivalents or alternatives within the technical scope of the present invention.

The terms "comprise" or "have", etc. are used herein to designate the presence of characteristics, numbers, steps, actions, components or members described in the specification or a combination thereof, and it should be understood that the possibility of the presence or addition of one or more other characteristics, numbers, steps, actions, components, members or a combination thereof is not excluded in advance.

FIG. 1 is a flowchart showing a flow of a manufacturing method of a lithium secondary battery according to an exemplary embodiment of the present invention. Referring to FIG. 1, a manufacturing method of a lithium secondary battery according to an exemplary embodiment of the present invention includes: (a) assembling a battery cell by accommodating an electrode assembly inside a battery case, and injecting an electrolyte; (b) pre-aging the battery cell injected with an electrolyte, wherein the pre-aging (b) includes: (b-1) applying a sound wave to the assembled battery cell using a speaker; and (b-2) aging the battery cell.

In order to remove air bubbles present inside an assembled battery cell, the manufacturing method of a lithium secondary battery of the present invention uses a speaker to locally apply sound waves to a region where air bubbles are expected to form in the battery cell after injecting an electrolyte. When sound waves are applied, air bubbles in the electrode assembly or the electrolyte are removed by the vibrational energy of the sound waves, thereby improving the wetting property of the electrolyte.

The manufacturing method of the lithium secondary battery of the present invention can be applied to cylindrical lithium secondary batteries, prismatic lithium secondary batteries, and pouch-type lithium secondary batteries, but particularly useful in prismatic lithium secondary batteries or cylindrical lithium secondary batteries containing a jelly-roll type electrode assembly in which non-uniformity of wetting property easily occurs in the winding center part and the winding outer part.

A jelly roll-type electrode assembly according to an exemplary embodiment of the present invention has a rolled shape in which electrodes and separators are alternately stacked. The electrode may be a first electrode and a second electrode having a different polarity from the first electrode. The first electrode may be a negative electrode, and the second electrode may be a positive electrode. The separator may be interposed between the first electrode and the second electrode.

The (a) assembling a battery cell accommodates an electrode assembly inside a battery case, and injects an electrolyte. A battery case accommodating the electrode assembly may be classified into a prismatic, a coin-type, a cylindrical, and a pouch-type, depending on the shape. The method of accommodating the electrode assembly in the case slightly varies depending on the shape (specific details are obvious to those skilled in the art, so they are not described in detail). Next, a process of injecting an electrolyte into the battery case is performed.

After the injection of the electrolyte is completed, a (b) pre-aging of aging a battery cell is performed so that the electrolyte is impregnated into the electrode assembly. The pre-aging of the present invention includes (b-1) applying sound waves to the battery cell using a speaker to remove air bubbles.

The (b-1) application of sound wave of the present invention may locally apply sound waves to a region where air bubbles are expected to form. When sound waves are applied, air bubbles are removed due to the vibration energy of the sound waves, but the vibration energy of the sound waves also acts on an electrode active material layer, and may cause deintercalation of some electrode active materials. Therefore, when sound waves are locally applied to a region where air bubbles are expected to form, negative effects of the sound waves on the electrode active material layer can be reduced.

A directional speaker, which is a means for applying sound waves, is selected, preferably to locally apply sound waves to a region where air bubbles are expected to form.

A directional speaker is a speaker having a strong directivity that radiates sound waves in a desired direction. A general speaker spreads sound waves to all directions, but a directional speaker transmits sound waves only in one direction instead of spreading sound waves, so that sound waves can be transmitted only in a desired direction.

A directional speaker according to an exemplary embodiment of the present invention is a device for reproducing an audio signal of an audible band from ultrasonic waves above the audible band, and is a high-tech acoustic device by a synthesis of ultrasonic waves and sound waves. The directional speaker of the present invention carries an audio signal (sound wave) of an audible band on an ultrasonic band signal and radiates it into the air, and the air recreates an audio signal within the ultrasonic angle of beam spread and radiates the sound only to a specific area. Here, the signal in the ultrasonic band is referred to as a carrier wave.

Since the directional speaker can intensively apply sound waves to a region where air bubbles are expected to form, the effect of removing air bubbles is excellent.

Since air bubbles are conventionally present in the electrolyte or at the end of the electrode assembly, the region to which sound waves are applied using the speaker may be one or more selected among the upper surface of the battery, the lower surface of the battery, and the side surface of the battery. Specifically, in the case of a cylindrical or a prismatic battery, sound waves can be applied to the upper and the lower surfaces of the battery, and in the case of a pouch-type battery, sound waves can be applied to the edge part of the body, that is the " 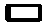 "-shaped part, of the battery. In addition, in the case of a jelly-roll type electrode assembly, since there is a high possibility that the electrolyte is not impregnated in the center part rather than the outer part, sound waves may be applied to the center part of the electrode assembly.

In the (b-1) applying sound waves, the frequency of the sound wave of the directional speaker is 20Hz to 20000Hz, preferably 30Hz to 15000Hz, and more preferably 50Hz to 10000Hz.

Also, in the (b-1) applying sound waves, the carrier wave of the directional speaker is ultrasonic waves, and the frequency of the carrier wave may be 20kHz to 100kHz, preferably 20kHz to 60kHz.

In the (b-1) applying sound waves, the frequency of the sound wave of the directional speaker may be constant, or may be in a form of being swept at a frequency within a predetermined range. All objects have one or more natural frequency that vibrates at a specific frequency, and when a vibration having the same frequency (resonant frequency) as the specific natural frequency of the object is applied from the outside, the amplitude of the object increases, so that when sound waves are applied, the frequency of the sound wave is swept, thereby having an excellent effect of removing air bubbles.

The air bubbles inside the battery may exist in the electrolyte, even inside the electrode assembly, and in the (b-1) applying sound waves, since the present invention applies sound waves of various frequencies while sweeping the frequency, there is an effect of removing air bubbles regardless of the size of the air bubbles as the electrolyte or the electrode material resonates.

In applying the sound waves in the (b-1) applying sound waves, the time for applying the sound wave once may be 10 seconds to 30 minutes, preferably 1 minute to 15 minutes. In addition, the total number of times the sound waves are applied may be specifically 1 time to 10 times, 2 times to 9 times, or 3 times to 8 times. In addition, the time interval from the application of sound waves to the next application of sound waves may be 10 seconds to 10 minutes, preferably 15 seconds to 7 minutes, and more preferably 30 seconds to 5 minutes. Additionally, the total time of sound wave application may be 2 minutes to 60 minutes, 3 minutes to 45 minutes, or 5 minutes to 30 minutes.

The (b-1) applying sound waves may apply sound waves in a state where the battery cell is sealed, or may apply sound waves in a state where the battery cell is not sealed.

The (b-2) aging of battery cell is leaving the battery cell under a constant temperature condition for a predetermined time so that the electrolyte is impregnated into the electrode assembly.

In one specific example, the (b-2) aging includes a process of aging the battery cell at a room temperature of 18°C to 28°C or a high temperature of 40°C to 70°C.

When a pre-aging is performed at room temperature, it may be performed at a room temperature condition of 18°C to 28°C, specifically 19°C to 27°C, more specifically 20°C to 26°C, and even more specifically 21°C to 25°C, but is not necessarily limited thereto, and may be appropriately changed depending on the characteristics of the battery to be designed.

When performing the pre-aging at a high temperature, it may be performed at a high temperature condition of 40°C to 70°C, specifically 45°C to 65°C, more specifically 44°C to 56°C, and more specifically 50°C to 60°C, but is not necessarily limited thereto, and may be appropriately changed depending on the characteristics of the battery to be designed. In the case of pre-aging at a high temperature, there is an advantage that the rate of impregnation of the electrolyte can be further increased.

The time required for the (b-2) aging may be specifically 3 hours to 60 hours, 6 hours to 48 hours, and 12 hours to 36 hours, and this may be appropriately adjusted according to the materials of the positive electrode, the negative electrode, and the electrolyte, the design capacity of the secondary battery, etc.

The manufacturing method of the lithium secondary battery of the present invention may include (c) activation charging of activating by charging the battery cell after the (b) pre-aging. The (c) activation charging is forming a SEI (Solid electrolyte interface, hereinafter referred to as "SEI") film layer of the negative electrode by charging the secondary battery, and it is a process of charging the assembled secondary battery to a SOC level within a predetermined range of full charge capacity (SOC 100, SOC; State Of Charge). Here, the SOC of the predetermined range may be SOC 20% to 80%, and more preferably SOC 40% to 70%.

In the lithium secondary battery, when a primary charging step is performed, lithium ions derived from a positive electrode active material contained in the positive electrode move to the negative electrode, and since the lithium ions are highly reactive, they react with the negative electrode to form compounds such as Li₂CO₃, LiO, LiOH, etc., and a SEI film is formed on the surface of the negative electrode by these compounds.

The SEI film is an insulator formed when the amount of ion movement in the battery increases, and when the SEI film is formed, it prevents the reaction between lithium ions and other materials in the negative electrode during a subsequent charging of the secondary battery, and it serves as a kind of ion tunnel to pass through lithium ions only. After this SEI film is formed, lithium ions do not react with the negative electrode or other materials, so the amount of lithium ions is reversibly maintained and the charge and discharge of the secondary battery is reversibly maintained, thereby improving the lifespan of the secondary battery. And since the battery is not easily collapsed even when it is left at high temperature or when it is charged/discharged repeatedly, the change in thickness of the battery is less likely to occur.

The primary charging may be performed under charging conditions according to conditions known in the art. Specifically, the charging method may perform charging in a constant current method until the charging end voltage is reached. Here, the charging rate (crate) may be 0.01C to 2C, 0.1C to 1.5C, and 0.2C to 1C, but is not necessarily limited thereto, and may be appropriately adjusted according to the material characteristics of the positive electrode and the negative electrode.

In addition, the temperature condition of the primary charging may be carried out at 18°C to 28°C, specifically 19°C to 27°C, and more specifically 20°C to 26°C.

In addition, the primary charging may perform charging while pressurizing the secondary battery. Specifically, the primary charging may be performed while being loaded on a jig formation device capable of pressurizing the secondary battery even during charging.

Here, the pressure for pressurizing the secondary battery may be 0.1kgf/cm² to 10kgf/cm², preferably 0.3kgf/cm² to 7.5kgf/cm², and more preferably 0.5kgf/cm² to 5kgf/cm².

The manufacturing method of a lithium secondary battery of the present invention may further include (d) aging of aging the battery after the (c) activation charging. The (d) aging is aging the secondary battery under various conditions in order to accelerate the stabilization of the SEI film formed through the activation charging.

The (d) aging may go through a room temperature aging in which the secondary battery is aged for a predetermined time under room temperature/normal pressure condition, and depending on the purpose, high temperature aging may be performed instead of room temperature aging, and both room temperature aging and high temperature aging may be performed. The high temperature aging ages the battery in a high temperature environment, and may accelerate the stabilization of the SEI film, and the high temperature aging and the room temperature aging may be sequentially performed on an initially charged battery.

In one specific example, the high temperature aging may be performed at a temperature of 50°C to 100°C, preferably 50°C to 80°C. The high temperature aging may be performed for 1 to 30 hours, preferably 2 to 24 hours. In the high temperature aging, the stabilization of the SEI film is accelerated, so that the voltage drop due to a self-discharge of a normal battery becomes low, thereby further improving the ability to distinguish good batteries from low-voltage defective batteries.

In one specific example, the room temperature aging may be performed at a temperature of 18°C to 28°C, specifically 19°C to 27°C, more specifically 20°C to 26°C, and even more specifically 21°C to 25°C. The room temperature aging may be performed for 12 hours to 120 hours, or 18 hours to 72 hours.

Additionally, the manufacturing method of a lithium secondary battery of the present invention may further include degassing of discharging the gas collected inside the secondary battery to the outside. For this degassing, various degassing techniques known at the time of filing the present invention may be adopted. Since this degassing technique is widely known to those skilled in the art, a detailed description thereof will be omitted.

In addition, the manufacturing method of a lithium secondary battery of the present invention may further perform a full discharge and a full charge process of completely discharging the secondary battery to near SOC 0 and then charging to 95% (SOC 95%) or more of the design capacity of the discharged secondary battery. The full discharge and the full charge process may be done by performing it once, or by repeating two or more times.

In one specific example, the manufacturing method of a secondary battery of the present invention may further perform an additional aging after the full discharge and the full charge process. The additional aging is a process of stabilizing the secondary battery, and may be specifically performed for 1 day to 21 days. In order to screen low-voltage defective batteries in which voltage drop occurs to a range exceeding the self-discharge of the battery, the additional aging may include a monitoring (OCV tracking) process of measuring an open circuit voltage (OCV) of the battery at regular time intervals.

Hereinafter, the present invention will be described in detail using exemplary embodiments to aid the understanding of the present invention. However, the exemplary embodiments according to the present invention may be modified in many different forms, and it should not be construed that the scope of the present invention is limited to the following exemplary embodiments. The exemplary embodiments of the present invention are provided to more completely explain the present invention to those skilled in the art.

### Preparation Example: Preparation of lithium secondary battery

A slurry for a positive electrode mixture layer was prepared by weighing 95 parts by weight of LiNi_{0.8}Co_{0.1}Mn_{0.1}O₂ as a positive electrode active material, 0.9 part by weight of Li₆Co_{0.7}Zn_{0.3}O₄ as a positive electrode additive, 1.6 parts by weight of PVdF as a binder, and 2.5 parts by weight of carbon black as a conductor and mixing them into a N-methylpyrrolidone (NMP) solvent. A positive electrode having a positive electrode mixture layer (average thickness: 130µm) was formed by applying the slurry for the mixture layer to an aluminum foil, drying it, and then rolling it.

A slurry for a negative electrode mixture layer was prepared by mixing 85 parts by weight of natural graphite as a carbon-based active material, 5 parts by weight of SiO as a silicon-based active material, 6 parts by weight of carbon black as a conductor, and 4 parts by weight of PVDF as a binder into a N-methylpyrrolidone (NMP) solvent. A negative electrode having a negative electrode mixture layer (average thickness: 180µm) was formed by applying the slurry for the mixture layer to an aluminum foil, drying it, and then rolling it.

A jelly-roll type electrode assembly was prepared by winding in a state in which a separator (thickness: approx. 16µm) made of a porous polyethylene (PE) film is interposed between each of the prepared positive electrodes and negative electrodes. After accommodating the jelly-roll type electrode assembly into a battery case of a cylindrical can, the assembly of the battery was completed by injecting an electrolyte into the battery case. As the electrolyte, an electrolyte in which 1M LiF₆ is dissolved in an organic solvent in which ethereal carbonate (EC) and ethyl methyl carbonate (EMC) are mixed in a composition of 3:7 (volumed ratio) was used.

### Example 1

Ten lithium secondary batteries assembled according to the Preparation Example were prepared, and sound waves were applied toward the side of the battery using a directional speaker while rotating the battery 360°. The frequency of the applied sound wave was 20 to 1000Hz, the sound wave was applied while sweeping the frequency, and the intensity of the sound wave was 110dB. The time required for applying sound waves once was 5 minutes, and the sound waves were applied a total of 2 times, and the time interval between the sound wave applications was 1 minute.

Thereafter, the battery was aged by being left at a temperature of 23°C for 24 hours.

### Example 2

Ten lithium secondary batteries assembled according to the Preparation Example were prepared, and sound waves were applied toward the side of the battery using a directional speaker while rotating the battery 360°. The frequency of the applied sound wave was 20 to 1000Hz, the sound wave was applied while sweeping the frequency, and the intensity of the sound wave was 110dB. The time required for applying sound waves once was 5 minutes, and the sound waves were applied a total of 2 times, and the time interval between the sound wave applications was 1 minute.

Thereafter, the battery was aged by being left at a temperature of 23°C for 24 hours.

### Comparative Example

Ten lithium secondary batteries assembled according to the Preparation Example were prepared, and were aged at a temperature of 23°C for 24 hours and 5 minutes.

### Experimental Example: Confirmation of wetting property

The area of the separator impregnated with the electrolyte was measured by disassembling the batteries of the Examples and the Comparative Example, and the average value was shown in Table 1. The average value of each impregnation area in Example 2 and Comparative Example 1 was expressed as a numerical value based on the average value of the area measured in Example 1.

**[Table 1]**

| | Example 1 | Example 2 | Comparative Example |
|---|---|---|---|
| Electrolyte impregnation area | 100% | 97% | 93% |

As such, the lithium secondary battery manufactured according to the exemplary embodiment of the present invention includes a process of removing air bubbles using a speaker, so that when the battery is aged for the same time as in the lithium secondary according to the Comparative Example, it has an improved electrolyte wetting property.

Accordingly, the manufacturing method of the lithium secondary battery of the present invention may be expected to shorten the time required for the pre-aging for electrolyte impregnation.

## Claims

1. A manufacturing method of a lithium secondary battery, comprising:
(a) assembling a battery cell by accommodating an electrode assembly inside a battery case, and injecting an electrolyte;
(b) pre-aging the battery cell into which an electrolyte is injected, wherein
the pre-aging (b) comprising:
(b-1) applying sound waves to the assembled battery cell using a speaker; and
(b-2) aging the battery cell, and
**characterised in that**
the speaker is a directional speaker, and
in (b-1) applying sound waves, the frequency of the sound wave of the speaker is 20Hz to 20000Hz and the carrier wave of the directional speaker is an ultrasonic wave.

2. The manufacturing method of a lithium secondary battery of claim 1, wherein
(b-1) applying sound waves includes locally applying sound waves to a region where air bubbles are expected to form.

3. The manufacturing method of a lithium secondary battery of claim 1, wherein
(b-1) applying sound waves includes applying sound waves while sweeping the frequency of the sound wave.

4. The manufacturing method of a lithium secondary battery of claim 1, further comprising
(c) activation charging of the battery cell after the (b) pre-aging.

5. The manufacturing method of a lithium secondary battery of claim 1, wherein
(b-1) applying sound waves includes applying sound waves in a state where the battery cell is sealed.

6. The manufacturing method of a lithium secondary battery of claim 1, wherein
(b-1) applying sound waves includes applying sound waves in a state where the battery cell is not sealed.

7. The manufacturing method of a lithium secondary battery of claim 1, wherein
in (b-1) applying sound waves, the frequency of the carrier wave of the directional speaker is 20kHz to 100kHz.

## Patentansprüche

1. Herstellungsverfahren für eine Lithium-Sekundärbatterie, umfassend:
(a) Zusammenbauen einer Batteriezelle durch Aufnehmen einer Elektrodenanordnung in einem Batteriegehäuse und Einspritzen eines Elektrolyten;
(b) Voraltern der Batteriezelle, in die ein Elektrolyt eingespritzt ist, wobei
das Voraltern (b) umfasst:
(b-1) Anwenden von Schallwellen auf die zusammengebaute Batteriezelle unter Verwendung eines Lautsprechers; und
(b-2) Altern der Batteriezelle, und
**dadurch gekennzeichnet, dass**
der Lautsprecher ein Richtlautsprecher ist, und
in (b-1) beim Anwenden von Schallwellen die Frequenz der Schallwelle des Lautsprechers 20 Hz bis 20000 Hz beträgt und die Trägerwelle des Richtlautsprechers eine Ultraschallwelle ist.

2. Herstellungsverfahren für eine Lithium-Sekundärbatterie nach Anspruch 1, wobei
(b-1) das Anwenden von Schallwellen das lokale Anwenden von Schallwellen auf einen Bereich, in dem die Bildung von Luftblasen erwartet wird, umfasst.

3. Herstellungsverfahren für eine Lithium-Sekundärbatterie nach Anspruch 1, wobei
(b-1) das Anwenden von Schallwellen das Anwenden von Schallwellen umfasst, während die Frequenz der Schallwelle gewobbelt wird.

4. Herstellungsverfahren für eine Lithium-Sekundärbatterie nach Anspruch 1, ferner umfassend
(c) Aktivierungsladen der Batteriezelle nach dem (b) Voraltern.

5. Herstellungsverfahren für eine Lithium-Sekundärbatterie nach Anspruch 1, wobei
(b-1) das Anwenden von Schallwellen das Anwenden von Schallwellen in einem Zustand, in dem die Batteriezelle abgedichtet ist, umfasst.

6. Herstellungsverfahren für eine Lithium-Sekundärbatterie nach Anspruch 1, wobei
(b-1) das Anwenden von Schallwellen das Anwenden von Schallwellen in einem Zustand, in dem die Batteriezelle nicht abgedichtet ist, umfasst.

7. Herstellungsverfahren für eine Lithium-Sekundärbatterie nach Anspruch 1, wobei
in (b-1) beim Anwenden von Schallwellen die Frequenz der Trägerwelle des Richtlautsprechers 20 kHz bis 100 kHz beträgt.

## Revendications

1. Procédé de fabrication d'une batterie secondaire au lithium, comprenant :
(a) l'assemblage d'une cellule de batterie en installant un ensemble d'électrodes à l'intérieur d'un boîtier de batterie, et en injectant un électrolyte ;
(b) le pré-vieillissement de la cellule de batterie dans laquelle un électrolyte a été injecté,
le pré-vieillissement (b) comprenant :
(b-1) l'application d'ondes sonores sur la cellule de batterie assemblée à l'aide d'un haut-parleur ; et
(b-2) le vieillissement de la cellule de batterie, et
étant **caractérisé en ce que**
le haut-parleur est un haut-parleur directionnel, et
dans l'application des ondes sonores à (b-1), la fréquence de l'onde sonore du haut-parleur est comprise entre 20 Hz et 20 000 Hz, et l'onde porteuse du haut-parleur directionnel est une onde ultrasonore.

2. Procédé de fabrication d'une batterie secondaire au lithium selon la revendication 1,
(b-1) l'application d'ondes sonores comprenant l'application locale d'ondes sonores dans une zone où la formation de bulles d'air est à prévoir.

3. Procédé de fabrication d'une batterie secondaire au lithium selon la revendication 1,
(b-1) l'application d'ondes sonores comprenant l'application d'ondes sonores tout en balayant la fréquence de l'onde sonore.

4. Procédé de fabrication d'une batterie secondaire au lithium selon la revendication 1, comprenant en outre
(c) l'activation de la charge de la cellule de batterie après le pré-vieillissement (b).

5. Procédé de fabrication d'une batterie secondaire au lithium selon la revendication 1,
(b-1) L'application d'ondes sonores comprenant l'application d'ondes sonores consiste dans un état où la cellule de la batterie est scellée.

6. Procédé de fabrication d'une batterie secondaire au lithium selon la revendication 1,
(b-1) l'application d'ondes sonores comprenant l'application d'ondes sonores dans un état où la cellule de la batterie n'est pas scellée.

7. Procédé de fabrication d'une batterie secondaire au lithium selon la revendication 1, dans lequel
lors de l'application (b-1) d'ondes sonores, la fréquence de l'onde porteuse du haut-parleur directionnel est comprise entre 20 kHz et 100 kHz.
